Europäisches Patentamt

European Patent Office

Office européen des brevets

(11) Numéro de publication : **0 461 955 A1**

# (12) DEMANDE DE BREVET EUROPEEN

(21) Numéro de dépôt : **91401450.1**

(22) Date de dépôt : **04.06.91**

(51) Int. Cl.⁵ : **H01L 21/338, H01L 29/52**

(30) Priorité : **12.06.90 FR 9007282**

(43) Date de publication de la demande :
**18.12.91 Bulletin 91/51**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Collot, Philippe**
**THOMSON-CSF ,SCPI, Cédex 67**
**F-92045 Paris la Défense (FR)**
Inventeur : **Schmidt, Paul Erick**
**THOMSON-CSF ,SCPI, Cédex 67**
**F-92045 Paris la Défense (FR)**

(74) Mandataire : **Taboureau, James et al**
**THOMSON-CSF SCPI**
**F-92045 Paris La Défense Cédex 67 (FR)**

(54) **Procédé d'autoalignement des contacts métalliques sur un dispositif semiconducteur, et semiconducteur autoaligné.**

(57)    L'invention se rapporte à la réalisation de contacts métalliques autoalignés sur les dispositifs semiconducteurs, avec un espacement submicronique entre régions contrôlées par les contacts.

Sur un corps semiconducteur (1) supportant au moins un motif (6) en relief, une double couche de $SiO_2$ (9) et de $Si_3N_4$ (10) est déposée par une méthode isotrope. Par une double gravure ionique de $Si_3N_4$ par SF6 et de $SiO_2$ par $CHF_3$, on isole des espaceurs isolants (11 + 13, 12 + 14) sur les flancs du motif (6). Une sous-gravure (17, 18) par $HF/NH_4F/H_2O$ crée une "casquette" sous chaque espaceur isolant. Les contacts métalliques (3, 4, 5) déposés par évaporation sont autoalignées et séparés d'un espace "d" égal à l'épaisseur des couches isolantes (11 + 13, 12 + 14).

FIG.8

EP 0 461 955 A1

La présente invention concerne un procédé d'autoalignement de contacts métalliques sur les semiconducteurs, dans lequel un espaceur isolant permet de réserver une distance submicronique entre deux régions voisines contrôlées par deux métallisations. L'invention s'applique aux dispositifs semiconducteurs tels que les transistors, et plus spécialement à ceux qui travaillent dans les hyperfréquences, domaine dans lequel les gardes entre régions voisines sont parfois submicroniques.

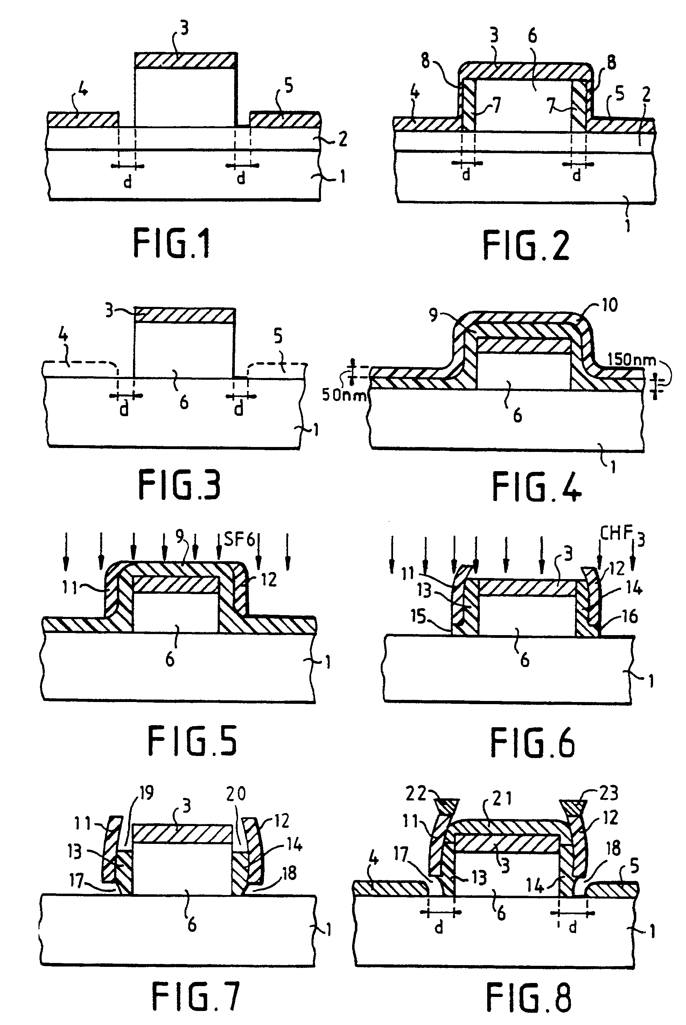

On sait que dans un transistor tel que schématisé en figure 1, comprenant au moins un substrat 1, une couche active 2, une région de commande 3, avec sa métallisation, et deux électrodes d'accès 4 et 5, il est important de diminuer les distances repérées "d" entre deux régions voisines. Dans le cas de figure, si le transistor est un transistor à effet de champ, il est important de diminuer la distance "d" entre source 4 et grille 3 et la distance "d" entre grille 3 et drain 5, pour plusieurs raisons.

La distance "d", considérée dans la couche active 2, détermine les résistances d'accès des régions de source 4 et de drain 5 à la région contrôlée par la grille 3 dans la couche active 2, et ces résistances d'accès interviennent dans les caractéristiques des transistors. Les résistances d'accès seront donc minimales, et les caractéristiques des transistors améliorées, si les distances "d" sont diminuées, sans toutefois être annulées car ce sont elles qui règlent la tenue en tension d'un transistor. Une valeur optimale serait de l'ordre de 100 nm, soit 0,1 micromètre.

Le procédé utilisé doit cependant réserver la possibilité de recharger les métallisations des électrodes en alliage AuGe/Ni/Au qui diminue la résistivité des prises de contacts.

Mais on sait également que les techniques actuelles ne donnent pas pleinement satisfaction, et le développement des transistors hyperfréquences ou des circuits intégrés à très haute densité d'intégration se heurte à ces problèmes de géométries submicroniques.

La technique usuelle de photolithographie UV, par l'imprécision relative sur l'alignement des masques, conduit à des valeurs de résistances d'accès importantes et non reproductibles, et les distances "d" sont rarement inférieures à 1 micron (1000nm).

Dans certaines techniques de grille en T, ou grille à casquette, la résistance d'accès est déterminée par une sous-gravure chimique du matériau de la région de grille 3, sous la métallisation, mais un mauvais contrôle de la sous-gravure conduit à des résistances d'accès non reproductibles.

Enfin, la technique de l'espaceur isolant, plus connue sous son nom anglais " sidewall", a été adoptée pour autoaligner une implantation ionique. Elle présente cependant une étape délicate mise en évidence sur la figure 2.

En bref, le procédé "sidewall" consiste à recouvrir un motif 6, en mésa sur la surface de la tranche semiconductrice 1+2, d'une couche uniforme d'un isolant tel que la silice. Par gravure ionique réactive RIE (reactive ionic etching), cette couche est supprimée sauf en 7, sur les flancs du motif 6:

l'épaisseur de la couche 7 définit la distance "d" de séparation entre deux régions voisines dans la couche active 2, avec une grande précision, qui est celle de la croissance d'une couche, que l'on sait bien contrôler.

Cependant, au cours du dépôt autoaligné des métallisations des électrodes 3,4 et 5, il arrive fréquemment qu'une fine pellicule métallique 8 se dépose sur les flancs du "sidewall" 7, présentant alors un risque de court-circuit entre électrodes. L'élimination de cette métallisation résiduelle 8 par un usinage ionique incliné du flanc du "sidewall" est délicate, car elle risque de dégrader les propriétés isolantes de l'espaceur 7, par conduction de surface après irradiation.

Le procédé selon l'invention évite les inconvénients cités précédemment. C'est un perfectionnement à la technologie "sidewall" classique. Selon l'invention, l'espaceur isolant est constitué de deux couches superposées en deux matériaux tels que la silice et le nitrure de silicium, ayant des caractéristiques très différentes de solubilité dans une solution d'attaque chimique. Par dissolution partielle de la couche la plus soluble, une sous-gravure est réalisée, qui permet de garantir l'isolement électrique entre les contacts auto-alignés, puisque la couche la moins soluble présente une "casquette". Cette sous-gravure, en interrompant la métallisation résiduelle du flanc du "sidewalll", permet de supprimer l'usinage ionique incliné.

De façon plus précise, l'invention concerne un procédé d'autoalignement des contacts métalliques sur un dispositif semiconducteur comportant au moins un motif avec relief sur un corps semiconducteur, caractérisé en ce qu'il comprend les opérations suivantes :

– sur les surfaces libres du corps et du motif, y compris les surfaces latérales de ce dernier, dépôt par une méthode isotrope d'une première couche isolante de silice $SiO_2$ puis d'une deuxième couche isolante de nitrure de silicium $Si_3N_4$, d'épaisseurs bien contrôlées,

– gravure ionique réactive, anisotrope, par $SF_6$, de la deuxième couche dans ses parties déposées sur la face libre du corps et sur le dessus du motif, les portions de cette couche déposées sur les flancs du motif restant inaltérées,

– gravure ionique réactive, anisotrope, par $CHF_3$, de la première couche, à l'exception de ses portions déposées sur les flancs du motif, qui sont masquées par les portions correspondantes de la deuxième couche,

– attaque chimique sélective et isotrope, par une solution tamponnée de HF/NH$_4$F/H$_2$O de la première couche, cette attaque créant une sous-gravure dans les portions de la première couche qui sont partiellement masquées par les portions correspondantes de la deuxième couche inattaquée par ladite solution sélective,

– métallisation autoalignée, par une méthode directionnelle, des contacts métalliques d'électrodes du dispositif semiconducteur, les portions juxtaposées des deux couches isolantes sur les flancs du motif constituant des espaceurs isolants entre les régions du dispositif semiconducteur contrôlées par deux métallisations voisines.

L'invention sera mieux comprise par la description plus détaillée d'un exemple de réalisation, appuyée sur les figures jointes en annexe, qui représentent :

– figures 1 et 2 : vues en coupe d'un dispositif semiconducteur selon l'art connu, exposées précédemment,

– figures 3 à 8 : différentes étapes du procédé de réalisation d'espaceurs isolants, selon l'invention.

De façon à être plus précise, la description de l'inscription sera faite en s'appuyant sur l'exemple d'un transistor à effet de champ, qui peut être réalisé soit en silicium, soit en matériaux rapides des groupes III-V ou II-VI tels que GaAs, GaAlAs etc... Sur les figures, le détail des couches composant le corps de ce transistor ainsi que le motif en relief n'est pas précisé, puisque la structure interne du transistor est hors du domaine de l'invention, qui concerne la réalisation de métallisations en surface, autoalignées, et séparées par des gardes submicroniques.

La structure de départ du procédé, en figure 3, comprend un corps 1 en matériau semiconducteur (substrat, couches tampons, couches actives etc...) à la surface duquel se trouve un motif en relief 6. Ce motif peut être formé soit par une mésa de matériaux semiconducteurs ayant déjà reçu une métallisation 3 en couche mince, par exemple WSiTi, soit par une métallisation de grille, mais qui dans ce cas est épaissie par recharge : il faut qu'elle ait des parois latérales. Sur cette structure, on cherche à déposer des métallisations autoalignées 4 et 5, isolées du motif 6 par des distances "d" submicroniques, par exemple 200 nm.

Sur cette structure, en figure 4, sont déposées, par une méthode telle que l'épitaxie en phase gazeuse (CVD), une première couche 9 de silice SiO$_2$ et une deuxième couche 10 de nitrure de silicium Si$_3$N$_4$. L'épitaxie par CVD assure la régularité de l'épaisseur des couches, car elle est isotrope, de telle sorte que si des épaisseurs respectives de 150 nm et 50 nm, par exemple, de SiO$_2$ et Si$_3$N$_4$ sont déposées sur les surfaces horizontales de la structure, les mêmes épaisseurs se retrouvent sur les flancs du motif 6. L'épitaxie par CVD est une méthode suffisamment précise et lente pour qu'il soit possible d'arrêter les dépôts et contrôler les épaisseurs à quelques couches atomiques près. L'épaisseur totale des deux couches 9 et 10 est égale à la distance "d" recherchée.

Les parties de la double couche isolante 9 + 10 qui recouvrent les emplacements des futures métallisations d'électrodes 3, 4 et 5 doivent être décapées.

En figure 5, par une gravure ionique réactive sèche, ou RIE, par SF6, seules les parties horizontales de la couche 10 de Si$_3$N$_4$ sont gravées, parce que ce procédé de gravure est directionnel. La couche 9 de SiO$_2$ est inaltérée, et de la couche 10 de Si$_3$N$_4$ ne restent que les flancs 11 et 12 autour du motif en relief 6, recouvert par SiO$_2$. L'action de la RIE par SF6 est schématisée sur la figure 5 par des flèches.

Cette première gravure par SF6 n'a attaqué qu'une seule des deux couches isolantes : les zones où doivent être déposés les contacts métalliques 3, 4 et 5 sont toujours recouvertes par une couche 9 de SiO$_2$. Par une seconde gravure ionique réactive sèche, par CHF$_3$ en figure 6, les parties horizontales de la couche 9 de SiO$_2$ sont gravées, et ne restent de cette couche que les flancs 13 et 14, qui adhèrent autour du motif en relief 6, parce qu'ils sont protégés par les flancs 11 et 12, et parce que la RIE est directionnelle et sélective. Le sandwich SiO$_2$ + Si$_3$N$_4$, 11 + 13 ou 12 + 14, définit les espaceurs isolants.

Cependant, la surface latérale externe de ces espaceurs isolants est relativement plane, c'est-à-dire que, par l'action directionnelle de la RIE, les surfaces 15 et 16 des couches de silice 13 et 14, à proximité du corps semiconducteur 1, sont gravées dans le prolongement des surfaces externes des couches 11 et 12 de Si$_3$N$_4$. Il s'ensuit que si l'on effectuait une métallisation sur une telle structure, on retomberait dans l'inconvénient du " sidewall " classique, signalé en figure 2 : des métallisations résiduelles sur les flancs entraîneraient des courts-circuits source-grille et grille-drain, ou bien nécessiteraient une gravure ionique inclinée.

L'opération suivante, en figure 7, va donc introduire au pied des espaceurs isolants une sous-gravure, ou profil en casquette. Cette sous-gravure est effectuée par voie humide, au moyen d'une solution standard tamponnée de HF/NH$_4$F/H$_2$O, connue sous le nom BOE. Elle a l'avantage de présenter une forte sélectivité, et grave SiO$_2$ environ 20 fois plus vite que Si$_3$N$_4$. La vitesse de gravure de SiO$_2$ est d'environ 100 nanomètres par minute, à température ambiante 15-20°C. Les flancs 11 et 12 de Si$_3$N$_4$ servent de masques de gravures et, en 15 secondes d'attaque, les flancs 13 et 14 de SiO$_2$ sont gravés sur une profondeur d'environ 25 nanomètres en 17 et 18, au pied des espaceurs isolants, ainsi d'ailleurs qu'en 19 et 20 en haut du motif en relief 6.

La structure est désormais adaptée pour des métallisations autoalignées. En figure 8, une évaporation de métaux, directionnelle, dépose simultanément les couches minces pour les électrodes d'accès 4 et 5 et pour l'électrode de contrôle sur le motif en relief 6 (couche repérée 21). Il faut observer que si l'électrode de contrôle est de type Schottky, il est préférable de la réaliser dès la première étape, en figure 3 : la métallisation de la figure 8 est de type ohmique. La recharge du contact de grille 3 par la couche 21 assure une diminution appréciable de la résistance électrique de grille. Accessoirement, les espaceurs isolants 11 et 12 en $Si_3N_4$ sont coiffés par une métallisation 22-23.

Dans la structure achevée, les régions contrôlées par les métallisations autoalignées 3, 4 et 5 sont séparées par des distances submicroniques "d", égales à l'épaisseur des espaceurs isolants 11 + 13 et 12 + 14, et les sous-gravures en 17 et 18 évitent les métallisations résiduelles sur les flancs des "sidewall".

## Revendications

1 - Procédé d'autoalignement des contacts métalliques sur un dispositif semiconducteur comportant au moins un motif avec relief (6) sur un corps semiconducteur (1), caractérisé en ce qu'il comprend les opérations suivantes :

– sur les surfaces libres du corps (1) et du motif (6), y compris les surfaces latérales de ce dernier, dépôt par une méthode isotrope d'une première couche isolante (9) de silice $SiO_2$ puis d'une deuxième couche isolante de nitrure de silicium $Si_3N_4$, d'épaisseurs bien contrôlées,

– gravure ionique réactive, anisotrope, par $SF_6$, de la deuxième couche (10) dans ses parties déposées sur la face libre du corps (1) et sur le dessus du motif (6), les portions (11, 12) de cette couche déposées sur les flancs du motif (6) restant inaltérées,

– gravure ionique réactive, anisotrope, par $CHF_3$, de la première couche (9) , à l'exception de ses portions (13, 14) déposées sur les flancs du motif (6), qui sont masquées par les portions correspondantes (1, 12) de la deuxième couche (10),

– attaque chimique sélective et isotrope, par une solution tamponnée de $HF/NH_4F/H_2O$ de la première couche (9), cette attaque créant une sous-gravure (17, 18) dans les portions (13, 14) de la première couche (9) qui sont partiellement masquées par les portions correspondantes (11, 12) de la deuxième couche (10) inattaquée par ladite solution sélective,

– métallisation autoalignée, par une méthode directionnelle, des contacts métalliques (3, 4, 5) d'électrodes du dispositif semiconducteur, les portions juxtaposées (11 + 13, 12 + 14) des deux couches isolantes (9, 10) sur les flancs du motif (6) constituant des espaceurs isolants entre les régions du dispositif semiconducteur contrôlées par deux métallisations voisines

2 - Procédé selon la revendication 1, caractérisé en ce que, l'épaisseur totale des deux couches isolantes (9, 10) étant submicronique, l'épaisseur "d" des espaceurs isolants (11 + 13, 12 + 14) est submicronique.

3 - Procédé selon la revendication 1, caractérisé en ce que, dans le cas où un contact métallique (3) est de type Schottky, sa métallisation est réalisée avant la première opération de dépôt de deux couches isolantes (9, 10).

4 - Procédé selon la revendication 1, caractérisé en ce qu'au moins une métallisation (3) en couche mince est rechargée en métal (21), en vue de diminuer sa résistance électrique.

5 - Dispositif semiconducteur, comportant, supporté par un corps semiconducteur (1), au moins un motif (6) en relief, et au moins deux contacts métalliques (3, 4) autoalignés dont l'un déposé sur le motif (6) en relief, ce dispositif étant caractérisé en ce qu'il comporte, sur les flancs du motif (6) en relief, au moins un espaceur isolant constitué par une première couche (13) de silice, recouverte par une deuxième couche (11) de nitrure de silicium, la première couche (13) étant sous-gravée (17) à proximité du corps semiconducteur (1).

6 - Dispositif semiconducteur selon la revendication 5, caractérisé en ce que c'est un transistor hyperfréquence, et en ce que les régions commandées par les deux contacts métalliques voisins (3, 4) sont séparées par une distance "d" submicronique, égale à l'épaisseur de l'espaceur isolant (11 + 13).

FIG.1

FIG.2

FIG.3

FIG.4

FIG.5

FIG.6

FIG.7

FIG.8

EP 0 461 955 A1

Office européen
des brevets

**RAPPORT DE RECHERCHE EUROPEENNE**

Numero de la demande

EP 91 40 1450

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IBM TECHNICAL DISCLOSURE BULLETIN. vol. 26, no. 7b, décembre 1983, NEW YORK US pages 3842 - 3844; H.H. CHAO et.al.: "STEPPED OXIDE SPACER PROCESS FOR SELF-ALIGNED SILICIDE WITHOUT BRIDGING" * le document en entier * | 1 | H01L21/338 H01L29/52 |

**DOMAINES TECHNIQUES RECHERCHES (Int. Cl.5)**

H01L

Le présent rapport a été établi pour toutes les revendications

| Lieu de la recherche | Date d'achèvement de la recherche | Examinateur |
|---|---|---|
| LA HAYE | 09 SEPTEMBRE 1991 | PHEASANT N.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

6